Europäisches Patentamt

European Patent Office

Office européen des brevets

(19)

(11) Veröffentlichungsnummer: **0 003 609**
**B1**

(12) **EUROPÄISCHE PATENTSCHRIFT**

(45) Veröffentlichungstag der Patentschrift: **30.09.81**

(51) Int. Cl.³: **H 01 L 31/16**

(21) Anmeldenummer: **79100412.0**

(22) Anmeldetag: **12.02.79**

(54) Hochspannungsfester Optokoppler.

(30) Priorität: **14.02.78 DE 2806167**

(43) Veröffentlichungstag der Anmeldung:
**22.08.79 Patentblatt 79/17**

(45) Bekanntmachung des Hinweises auf die Patenterteilung:
**30.09.81 Patentblatt 81/39**

(84) Benannte Vertragsstaaten:
**FR GB IT**

(56) Entgegenhaltungen:
**DE - A - 2 304 148**
**US - A - 3 476 942**
**US - A - 3 845 318**

(73) Patentinhaber: **SIEMENS AKTIENGESELLSCHAFT**
**Berlin und München**
**Postfach 22 02 61**
**D-8000 München 22 (DE)**

(72) Erfinder: **Felkel, Gerfried, Dipl.-Phys.**
**Pappelstrasse 78**
**D-8014 Neubiberg (DE)**
Erfinder: **Klann, Jörg**
**Am Kronbügl 31**
**D-8411 Laaber (DE)**

Courier Press, Leamington Spa, England.

### Hochspannungsfester Optokoppler

Die Erfindung betrifft einen hochspannungsfesten Optokoppler, mit einem jeweils auf einem Leiterband angeordneten Strahlungssender beziehungsweise Strahlungsemgfänger, zwischen denen ein strahlungsdurchlässiges Koppelmedium vorgesehen ist, das wenigstens teilweise von einer strahlungsundurchlässigen Masse umhüllt ist.

Es gibt bereits einen Optokoppler (DE—OS 27 03 456), bei dem zwischen dem Strahlungssender und dem Strahlungsempfänger eine Glasschicht hoher Durchschlagsfestigkeit angeordnet ist, um so den Optokoppler bei höheren Spannungen betreiben zu können.

Wenn bei einem Optokoppler das Koppelmedium und die dieses umhüllende Masse aus verschiedenen Werkstoffen bestehen, so hat sich gezeigt, daß ein elektrischer Durchschlag in erster Linie an der Grenzfläche zwischen dem Koppelmedium und der Umhüllungsmasse auftritt. Daher werden oft Optokoppler hergestellt, bei denen das Koppelmedium und die Umhüllungsmasse aus dem gleichen Werkstoff bestehen. Trotzdem werden aber für viele Anwendungsfälle Optokoppler mit unterschiedlichen Werkstoffen für das Koppelmedium und die Umhüllungsmasse bevorzugt, so daß in der Fertigung derzeit zwei Fertigungsstraßen eingesetzt werden, nämlich eine Fertigungsstraße für hochspannungsfeste Optokoppler mit einem Werkstoff für Koppelmedium und Umhullungsmasse und eine weitere Fertigungsstraße für Optokoppler mit verschiedenen Werkstoffen für Koppelmedium und Umhüllungsmasse.

Es ist nun Aufgabe der Erfindung, einen Optokoppler mit verschiedenen Werkstoffen für Koppelmedium un Umhüllungsmasse auzugeben, der aber dennoch ausreichend hochspannungsfest gegenüber Spannungsdurchschlägen au der Grenzfläche zwischen Koppelmedium un Umhüllungsmasse ist.

Diese Aufgabe wird erfindungsgemäß dadurch gelöst, dass wenigstens ein Leiterband samt Strahlungssender bzw. -empfänger mit einem strahlungsdurchlässigen Isolierfilm überzogen ist, um Spannungsdurchschläge an der Grenzfläche zwischen Koppelmedium und Umhüllungsmasse zu verhindern.

Der Isolierfilm, der zum Beispiel aus Siliconlack oder Epoxydlack bestehen kann, wird nach dem Aufbringen des Strahlungssenders beziehungsweise Strahlungsempfängers auf das Leiterband aufgetragen und verhindert so einen Durchschlag an der Grenzfläche zwischen dem Koppelmedium und der Umhüllungsmasse. Dadurch kann die Durchschlagsfestigkeit des Optokopplers um bis zu 10 kV erhöht werden. Durch die Verwendung eines strahlungsdurchlässigen Isolierfilms ist das Überziehen des Strahlungssenders bzw. -empfängers ohne die Notwendigkeit einer auschliessenden Enthermung des Films im Bereich dieser Bauelemente möglich.

Außerdem ist vorteilhaft, wenn die Umhüllungsmasse eine Siliconpreßmasse oder eine Epoxydpreßmasse oder Gießharz ist.

Schließlich besteht eine Weiterbildung der Erfindung noch darin, daß der Isolierfilm auf den Lieterbändern bis in die Nähe des Austritts der Leiterbänder aus der Umhüllungsmasse reicht. Dadurch wird gewährleistet, daß kein elektrischer Durchschlag um den Isolierfilm herum zur Grenzfläche zwischen Koppelmedium und Umhüllungsmasse auftreten kann.

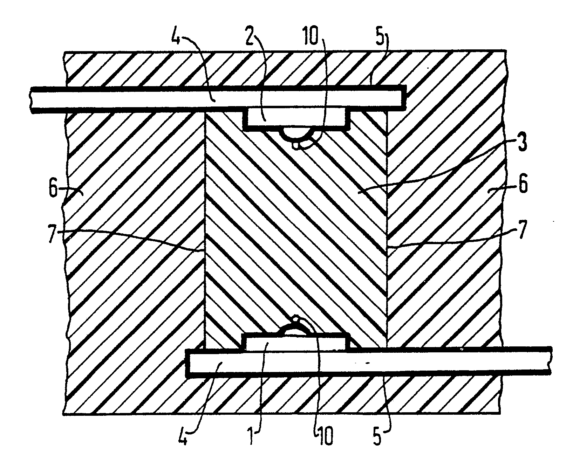

Nachfolgend wird die Erfindung an Hand der Zeichnung näher erläurtet, in deren einziger Figur der erfindungsgemäße hochspannungsfeste Optokoppler gezeigt ist:

Auf Leiterbändern 4 werden ein Strahlungssender 1 beziehungsweise Strahlungsempfänger 2 aufgebracht. Der Strahlungssender 1 kann eine Leuchtdiode sein, während für den Strahlungsempfänger 2 eine Photodiode oder ein Phototransistor vorgesehen werden kann. Zwischen dem Strahlungssender 1 und dem Strahlungsempfänger 2 befindet sich ein Koppelmedium 3 aus zum Beispiel Siliconlack. Das Koppelmedium 3 ist durch eine Umhüllungsmasse 6 aus Siliconpreßmasse umhüllt, die im Gegensatz zum Koppelmedium 3 lichundurchlässig ist.

Die Anschlußdrähte 10 des Strahlungssenders 1 beziehungsweise des Strahlungsempfängers 2 sind nur schematisch dargestellt und führen jeweils zu den Leiterbändern 4.

Wenn eine Hochspannung zwischen dem Strahlungssender 1 und dem Strahlungsempfänger 2 gelegt wird, kann ein elektrischer Durchschlag vorzugsweise an der Grenzfläche 7 zwischen dem Koppelmedium 3 und der Um hüllungsmasse 6 auftreten.

Dieser Durchschlag wird nun erfindungsgemäß dadurch verhindert, daß ein Isolierfilm aus zum Beispiel Siliconlack auf die Leiterbänder 4 bis nahe zu deren Austritt aus der Umhüllungsmasse 6 aufgetragen wird. Dieser Isolierfilm ist lichtdurchlässig und kann somit auch den Strahlungssender 1 beziehungsweise den Strahlungsempfänger 2 überdecken, ohne die Funktion des Optokopplers zu beeinträchtigen.

**Patentansprüche**

1. Hochspannungsfester Optokoppler, mit einem jeweils auf einem Leiterband angeordneten Strahlungssender beziehungsweise Strahlungsempfänger, zwischen denen ein strahlungsdurchlässiges Koppelmedium vorgesehen ist, das wenigstens teilweise von einer strahlungsundurchlässigen Masse umhüllt ist, dadurch gekennzeichnet dass wenigstens ein Leiterband samt Strahlungssender bzw. empfänger mit einem strahlungsdurchlässigen Isolierfilm überzogen ist, um spannungsdurchschläge an der Grenzfläche zwischen Koppelmedium und Unhüllungsmasse zu verhindern.

2. Optokoppler nach Anspruch 1, dadurch gekennzeichnet, daß der Isolierfilm (5) aus Siliconlack besteht.

3. Optokoppler nach Anspruch 1, dadurchgekennzeichnet, daß der Isolierfilm (5) aus Epoxydlack besteht.

4. Optokoppler nach einem der Ansprüche 1 bis 3, dadurch gekennzeichnet, daß der Isolierfilm (5) aus dem gleichen Werkstoff wie das Koppelmedium (3) besteht.

5. Optokoppler nach einem der Ansprüche 1 bis 4, dadurch gekennzeichnet, daß die Umhüllungsmasse (6) eine Siliconpreßmasse oder eine Epoxydpreßmasse oder Gießharz ist.

6. Optokoppler nach einem der Ansprüche 1 bis 5 dadurch gekennzeichnet, daß der Isolierfilm (5) auf de Leiterbändern (4) bis in die Nähe des Austritts der Leiterbändern (4) aus der Umhüllungsmasse (6) reicht.

## Claims

1. A high-voltage-stable optocoupler comprising a radiation transmitter and a radiation receiver which are each arranged on a respective conductor strip and between which there is arranged a coupling medium which allows radiation to pass and which is at least partially enveloped by a mass which is opaque to radiation, characterised in that at least one conductor strip and the radiation transmitter or the radiation receiver as the case may be, are covered with an insulating film, through which radiation can pass, in order to prevent high voltage breakdowns at the boundary surface between the coupling medium and the enveloping mass.

2. An optocoupler as claimed in Claim 1, characterised in that the insulating film (5) consists of silicone varnish.

3. An optocoupler as claimed in Claim 1, characterised in that the insulating film (5) consists of epoxide varnish.

4. An optocoupler as claimed in one of Claims 1 to 3, characterised in that the insulating film (5) consists of the same material as the coupling medium.

5. An optocoupler as claimed in one of Claims 1 to 4, characterised in that the enveloping mass (6) is a moulded silicone mass or a moulded epoxide resin mass, or cast resin.

6. An optocoupler as claimed in one of Claims 1 to 5, characterised in that the insulating film (5) on the conductor strips (4) reaches to the vicinity of the egress of the conductor strip from the enveloping mass (6).

## Revendications

1. Optocoupleur résistant à la haute tension, comprenant un émetteur de rayonnement et un récepteur de rayonnement, qui sont disposés respectivement sur une bande conductrice et entre lesquels est interposé un milieu de couplage transparent au rayonnement et enrobé au moins partiellement d'une masse opaque au rayonnement, caractérisé en ce qu'au moins une bande conductrice, ainsi que l'émetteur de rayonnnement et le récepteur de rayonnement, est revêtue d'une pellicule isolante transparente au rayonnement, afin d'éviter des claquages dûs à la tension à la surface de séparation entre le milieu de couplage et la masse d'enrobage.

2. Optocoupleur suivant la revendication 1, caractérisé en ce que la pellicule (5) isolante est constituée d'une laque siliconée.

3. Optocoupleur suivant la revendication 1, caractérisé en ce que la pellicule (5) isolante est constituée d'une laque époxy.

4. Optocoupleur suivant l'une des revendications 1 à 3, caractérisé en ce que la pellicule (5) isolante est en le même matériau qu le milieu (3) de couplage.

5. Optocoupleur suivant l'une des revendications 1 à 4, caractérisé en ce que la masse (6) d'enrobage est une masse à mouler siliconée ou une masse à mouler époxy ou une résine de coulée.

6. Optocoupleur suivant l'une des revendications 1 à 5, caractérisé en ce que la pellicule (5) isolante arrive sur les bandes (4) conductrices jusqu'au voisinage de la sortie des bandes (4) conductrices de la masse (6) d'enrobage.